Europäisches Patentamt

European Patent Office

Office européen des brevets

(11) Numéro de publication: **0 418 119 A1**

## (12) DEMANDE DE BREVET EUROPEEN

(21) Numéro de dépôt: 90402428.8

(51) Int. Cl.5: **H05K 5/06**

(22) Date de dépôt: 04.09.90

(30) Priorité: 05.09.89 FR 8911573

(43) Date de publication de la demande:
20.03.91 Bulletin 91/12

(84) Etats contractants désignés:
DE GB IT SE

(71) Demandeur: THOMSON-CSF
51, Esplanade du Général de Gaulle
F-92800 Puteaux(FR)

(72) Inventeur: Billet, Daniel
THOMSON-CSF SCPI Cédex 67
F-92045 Paris la Défense(FR)
Inventeur: Buchholtzer, Bernard
THOMSON-CSF SCPI Cédex 67
F-92045 Paris la Défense(FR)
Inventeur: Droguet, Jean-Paul
THOMSON-CSF SCPI Cédex 67
F-92045 Paris la Défense(FR)
Inventeur: Teissier, Gérard
THOMSON-CSF SCPI Cédex 67
F-92045 Paris la Défense(FR)

(74) Mandataire: Turlèque, Clotilde et al
THOMSON-CSF SCPI
F-92045 PARIS LA DEFENSE CEDEX 67(FR)

(54) Module électronique étanche et d'encombrement réduit.

(57) Module électronique étanche et d'encombrement réduit comportant un container (1) et des circuits électroniques placés à l'intérieur du container, tel que le container (1) est fermé hermétiquement par un bouchon (2) comportant une fente conique au travers de laquelle passe une limande souple (3) destinée à assurer les connexions électriques entre le module électronique et des dispositifs extérieurs, cette fente étant comblée par au moins une matière plastique (12, 13) résistant à la pression hydrostatique et présentant une bonne adhérence sur la limande (3) et les parois du bouchon (2) pour assurer l'étanchéité du module électronique.

FIG_3

EP 0 418 119 A1

## MODULE ELECTRONIQUE ETANCHE ET D'ENCOMBREMENT REDUIT

La présente invention concerne un module électronique étanche et d'encombrement réduit destiné être immergé.

Elle s'applique notamment aux modules électroniques utilisés dans les matériels d'exploration sous-marine. Ces modules électroniques doivent être relativement petits pour réduire au maximum l'encombrement des matériels les utilisant et ils doivent être étanches et résister de fortes pressions car ils sont destinés a être immergés.

Il est connu de réaliser des modules électroniques étanches et résistant à de fortes pressions, comportant des circuits électroniques enfermés dans des containers cylindriques dont l'une des parois circulaires comporte des trous permettant de passer des broches métalliques assurant les connexions électriques entre les modules électroniques et des dispositifs extérieurs, tels que des capteurs ou des dispositifs de commande.

L'étanchéité de ces modules électroniques au niveau des connexions électriques est obtenue par la technique des "perles de verre" c'est-a-dire en coulant du verre dans les trous des containers entourant chacune des broches métalliques.

Cependant, cette technique de traversées par "perles de verre" est très conteuse par rapport au coût des circuits électroniques seuls et présente un encombrement important car le diamètre du container doit être suffisant pour permettre le passage de toutes les broches métalliques de connexion nécessaires. Par ailleurs, les circuits électroniques comportent généralement des composants discrets et présentent donc également un encombrement important.

Pour minimiser l'encombrement des modules électroniques et assurer leur étanchéité a un coût moindre, selon l'invention, le module électronique destiné a être immergé dans un milieu fluide extérieur et comportant un container fermé hermétiquement par un bouchon, et des circuits électroniques placés à l'intérieur du container, est caractérisé en ce que le bouchon comporte une fente au travers de laquelle passe une limande souple destinée à assurer des connexions électriques entre le module électronique et des dispositifs extérieurs, cette fente étant comblée par au moins une matière plastique résistant à la pression hydrostatique, stable vis-à-vis du milieu fluide extérieur avec lequel elle est destinée à être mise en contact et présentant une bonne adhérence sur la limande et sur les parois du bouchon, pour assurer l'étanchéité du module électronique.

D'autres particularités et avantages de l'invention apparaîtront clairement dans la description suivante donnée à titre d'exemple non limitatif et faite en regard des figures annexées qui représentent :
- la figure 1, une vue en coupe d'un module électronique étanche, selon l'invention,
- la figure 2, une vue en coupe de la connectique entre substrats, selon l'invention,
- la figure 3, une vue en coupe du passage étanche pratiqué dans le bouchon du container, selon l'invention.

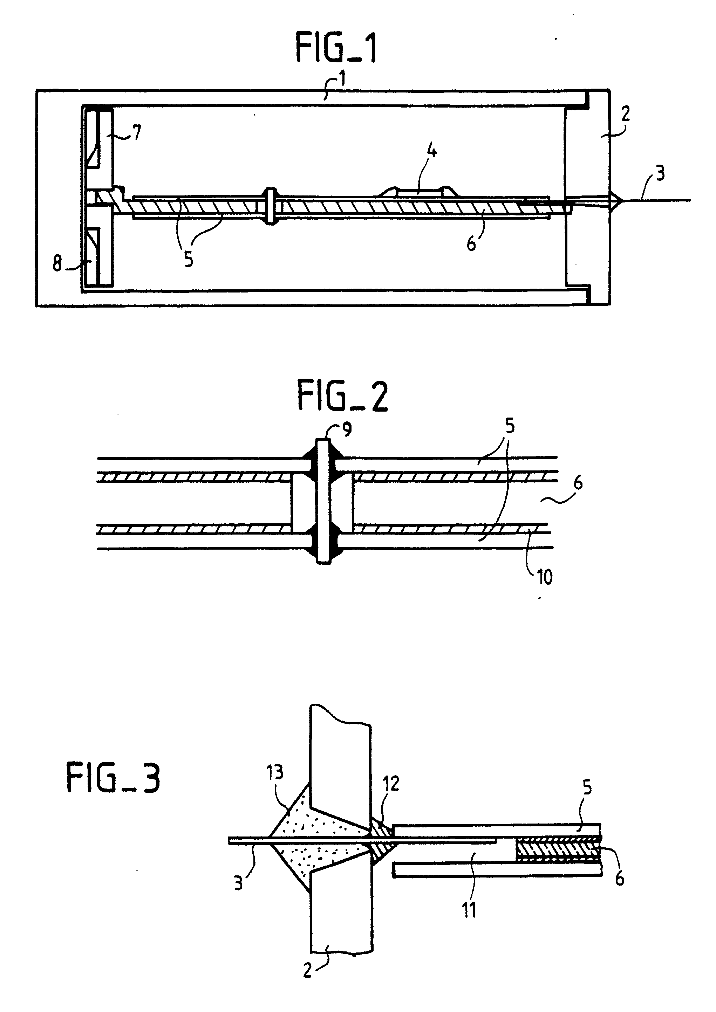

La figure 1 représente une vue en coupe d'un module électronique étanche, selon l'invention. Ce module électronique comporte un container, par exemple cylindrique, 1 fermé hermétiquement par un bouchon 2, dans lequel sont enfermés des circuits électroniques, et comporte une connectique d'entrée-sortie réalisée par une "limande" souple 3. Des composants électroniques 4 sont implantés suivant la technologie hybride à puces nues.

Le container 1 est réalisé dans un matériau permettant de réduire au maximum son épaisseur afin d'optimiser l'encombrement du module électronique tout en conservant une bonne tenue mécanique car il est destiné à être immergé. Par exemple, il est possible de réduire l'épaisseur du container cylindrique à 1mm tout en gardant une tenue mécanique suffisante en utilisant, par exemple, un alliage de titane ou un alliage d'aluminium.

Pour obtenir un niveau d'intégration maximum, les circuits électroniques comportent deux substrats en céramique 5 reportés de part et d'autre d'un support métallique 6.

Le support métallique 6 est centré dans le container à l'aide d'une rondelle de centrage 7 dont l'élasticité est assurée par un ressort de compensation 8.

La figure 2 représente une vue en coupe de la connectique entre substrats 5, selon l'invention. Les liaisons électriques entre les deux substrats 5 sont assurées par des broches métalliques 9 soudées dans des trous métallisés pratiqués dans les substrats. Le support métallique 6 comporte des trous dont le diamètre est suffisant pour assurer l'isolement électrique des broches 9. Les substrats 5 sont reportés sur le support métallique 6 par collage à l'aide d'une résine époxy isolante 10 déposée par sérigraphie avec épargne autour des trous métallisés. Après polymérisation de la résine 10, les broches 9 sont positionnées et soudées à l'aide d'un alliage tendre.

La figure 3 représente une vue en coupe du passage étanche pratiquée dans le bouchon 2 du container cylindrique 1. Le bouchon fermant le container métallique 1 est réalisé dans le même matériau que celui-ci et assure l'étanchéité des circuits électroniques hybrides placés dans le container. La présence de puces nues impose d'effectuer la fermeture du container 1 dans une enceinte étanche balayée par un gaz neutre contrôlé en humidité. Compte tenu de la forme du container et des contraintes imposées telles que l'herméticité et la tenue à haute pression, les modes de fermeture classiques tels que joint torique, colle ou vissage par exemple, sont inadaptées. La technologie de fermeture par soudure à l'aide d'un alliage convient bien mais la soudure par laser est plus facile à mettre en oeuvre et pré sente une grande fiabilité.

Les liaisons électriques d'entrée et de sortie du module électronique hybride sont réalisées par la limande souple 3 en polyimide soudée sur un peigne métallique à l'extrémité de l'un des substrats en céramique 5. Le support métallique 6 est évidé pour pouvoir loger la limande, l'évidement 11 étant ensuite rempli de la même résine que celle du collage des substrats sur le support métallique. La limande souple 3 traverse le container 1 par une fente conique pratiquée dans le bouchon 2.

Selon un premier mode de réalisation, pour assurer l'herméticité du container 1 et sa tenue aux contraintes d'environnement, une matière plastique, 12, 13, par exemple une résine, est insérée dans la fente conique du bouchon. Dans le type d'application envisagée ici la résine doit présenter à la fois une bonne mouillabilité et une bonne adhérence au niveau de la limande 3 et des parois du bouchon 2 pour obtenir une bonne étanchéité du module électronique, une inertie chimique vis-à-vis du kérosène pour éviter la dégradation de la résine au contact éventuel avec celui-ci, une résistance mécanique élevée par la tenue à haute pression, et une faible teneur en ions hydrolysables pour être compatible avec la technologie hybride à puces nues. Plusieurs résines paraissant comporter ces caractéristiques essentielles ont été soumises à de nombreux tests. Notamment des essais de tenue dans du kérosène, puis des études d'herméticité et de tenue aux variations rapides de température ont été effectués. A l'issue de ces essais, les résines époxy chargées à l'alumine ont été écartées à cause de leur dégradation par une absorption du kérosène. Parmi les autres types de résine, une résine a été sélectionnée pour sa facilité de mise en oeuvre et a été soumise à des tests plus complets, tels que notamment, l'évolution du taux de fuite après immersion dans du kérosène. Une absorption en surface du kérosène par la résine a été mise en évidence, mais ce phénomène est réversible après quelques heures d'attente. Par ailleurs, aucune dégradation de la résine n'a été mise en évidence après plusieurs jours d'immersion dans le kérosène.

Selon un deuxième mode de réalisation, le problème d'absorption en surface du kérosène par la résine est résolu par l'association de deux résines 12, 13, comme représenté sur la figure 3. Ces deux résines présentent une résistance mécanique élevée et une bonne adhérence sur la limande polyimide 3 et sur les parois du bouchon 2. Du côté intérieur, la résine 12, tel que par exemple la résine époxy commercialisée par la société DEXTER HYSOL sous le nom de HYSOL ES 4322, présente en outre une très faible teneur en ions hydrolysables pour être compatible avec la technologie hybride à puces nues, tandis que du côté extérieur, la résine 13, tel que par exemple la résine commercialisée par la société CIBA-GEIGY sous le nom de REDUX 410, présente en outre une inertie chimique vis-à-vis du kérosène (absence totale d'absorption). La résine intérieure 12 s'étend du côté intérieur du container 1, dans le prolongement de la fente conique en épousant les bords de la paroi interne du bouchon 2, le long de la limande souple 3 et jusqu'au substrat en céramique 5 sur lequel est soudée la limande. La résine extérieure 13 s'étend de la résine intérieure 12 vers l'extérieur du container 1 le long de la limande 3 en remplissant complètement la fente conique et au-delà en épousant les bords de la paroi externe du bouchon 2.

Tous les tests précédemment effectués lors de l'utilisation d'une seule résine ont été de nouveau effectués pour l'association de ces deux résines.

A l'issue de ces essais, aucune variation sensible du taux de fuite n'a été relevé, aucune dégradation des résines 12, 13 et aucun décollement des résines 12, 13 au niveau du bouchon 2 et de la limande 3 n'ont été observés. De même les résines présentent une bonne tenue à de fortes variations de pression.

**Revendications**

1. Module électronique étanche et d'encombrement réduit destiné à être immergé dans un milieu fluide extérieur et comportant un container (1) fermé hermétiquement par un bouchon, et des circuits électroniques placés à l'intérieur du container, caractérisé en ce que le bouchon (2) comporte une fente au travers de laquelle passe une limande souple (3) destinée à assurer des connexions électriques entre le module électronique et des dispositifs extérieurs, cette fente étant comblée par au moins une matière plastique (12, 13) résistant à la pression hydrostatique, stable vis-à-vis du milieu fluide extérieur avec lequel elle est destinée à être mise en contact et présentant une bonne adhérence sur la limande (3) et sur les parois du bouchon (2), pour assurer l'étanchéité du module électronique.

2. Module électronique selon la revendication 1, caractérisé en ce que le milieu fluide dans lequel est immergé le module électronique comporte du kérosène, et en ce que la matière plastique (12, 13) est stable vis-à-vis du kérosène.

3. Module électronique selon la revendication 1, caractérisé en ce que les circuits électroniques sont des circuits hybrides à puces nues.

4. Module électronique selon les revendications 2 et 3, caractérisé en ce que la fente pratiquée dans le bouchon (2) est comblée par deux matières plastiques (12, 13) dont l'une, placée près du module électronique, est une résine époxy qui présente une très faible teneur en ions hydrolysables pour être compatible avec la technologie hybride à puces nues et dont l'autre, en contact avec le milieu extérieur, est une résine présentant une inertie chimique vis-à-vis du kérosène.

5. Module électronique selon la revendication 4, caractérisé en ce que la fente pratiquée dans le bouchon (2) est conique.

6. Module électronique selon la revendication 3, caractérisé en ce que les circuits électroniques comportent deux substrats en céramique (5) reportés de part et d'autre d'un support métallique (6) et en ce que les liaisons électriques entre les deux substrats (5) sont assurées par des broches métalliques (9).

7. Module électronique selon la revendication 6, caractérisé en ce que les broches métalliques (9) sont soudées dans des trous métallisés pratiqués dans les substrats (5).

8. Module électronique selon l'une quelconque des revendications précédentes, caractérisé en ce que le matériau constituant le bouchon (2) est le même que celui du container (1).

9. Module électronique selon la revendication 8, caractérisé en ce que le bouchon (2) est soudé au container (1) par laser.

# FIG_1

# FIG_2

# FIG_3

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | DE-B-2 233 298 (SEL) <br> * colonne 1, lignes 35-42,60-68; figure 1 * | 1 | H 05 K    5/06 |
| A | --- | 9 | |
| Y | REVIEW OF THE ELECTRICAL COMMUNICATIONS LABORATORIES vol. 34, no. 1, 1986, pages 73-77, Tokyo, JP; I. KITAZAWA et al.: "Submarine Optical Repeater Housing" <br> * page 73, colonne de gauche, alinéa 1; page 74, colonne de droite, alinéa 2; figure 1 * | 1 | |
| A | idem <br> --- | 4,5 | |
| A | PATENT ABSTRACTS OF JAPAN vol. 6, no. 87 (E-108)(965), 25 mai 1982; & JP - A - 57021844 (SHINETSU KAGAKU KOGYO K.K.) 04.02.1982 <br> * le document en entier * <br> --- | 1 | |
| A | DE-A-3 434 086 (SIEMENS) <br> * page 3, lignes 4-8; figures 1,2 * <br> ----- | 1,3 | **DOMAINES TECHNIQUES RECHERCHES (Int. Cl.5)** <br><br> H 05 K    5/00 |

Le présent rapport a été établi pour toutes les revendications

| Lieu de la recherche | Date d'achèvement de la recherche | Examinateur |
|---|---|---|
| BERLIN | 10-12-1990 | ALEXATOS G |